# EUROPEAN PATENT APPLICATION

(11) **EP 3 001 565 A1**
(43) Date of publication of application: **30.03.2016**
(21) Application number: 15186399.0
(22) Date of filing: 23.09.2015
(51) Int. Cl.: H03K 17/693, H04B 1/48

(54) **BODY BIASING FOR RF SWITCH OPTIMIZATION**

(30) Priority: 23.09.2014 US 201414493695
(71) Applicant: ACCO, 78430 Louveciennes (FR)
(72) Inventor: Cam, Hervé, PALO ALTO, CA California 94306 (US); Blamon, Guillaume, PALO ALTO, CA California 94306 (US)
(74) Representative: Tischner, Oliver

(57) **Abstract**

Switches comprising a number of transistors in series achieve improved performance through biasing the bodies of the transistors to lower the stack resistance in the ON mode and optionally to also lower the stack capacitance in the OFF mode. These switches find use in RF applications such as phase shifters, step attenuators, and in antenna switches, for example. In some embodiments, a bias network is used to alternatingly provide a positive bias voltage or a negative bias voltage to the bodies of the transistors.

## Description

### CROSS-REFERENCE TO RELATED APPLICATIONS

This application is related to U.S. Patent Application No. 14/183,215 filed on February 18, 2014 and entitled "Switch Controls" which is incorporated herein by reference.

### BACKGROUND

### Field of Invention

The present invention relates generally to RF circuits and more particularly to switches usable for activating and deactivating RF paths, including switching an antenna between multiple transit paths, and other applications.

### Related Art

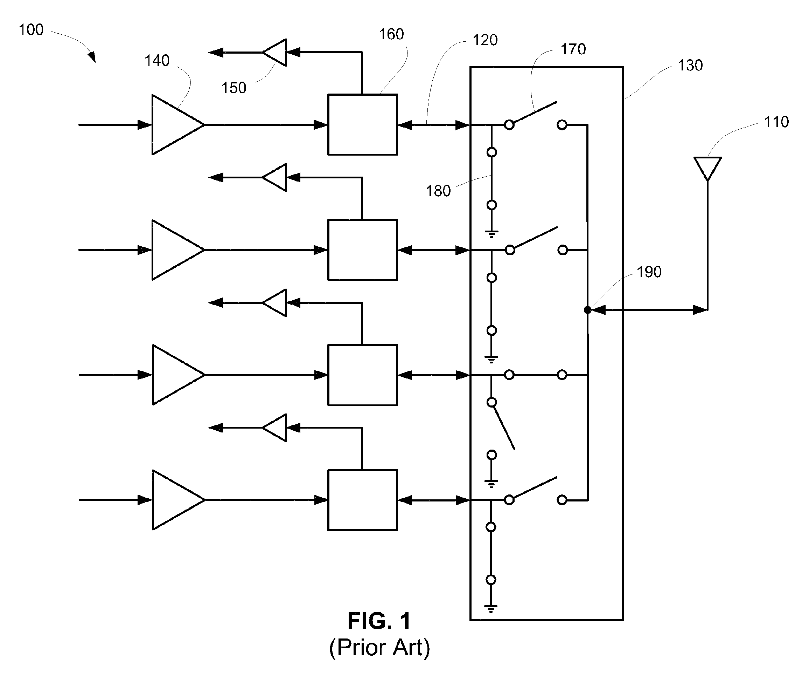

FIG. 1 illustrates a prior art RF circuit 100 coupled to an antenna 110. The circuit 100 comprises a number of transit paths 120 and an antenna switch 130 that couples the antenna 110 to the several transit paths 120. Each transit path 120 includes a power amplifier 140 and a receiver amplifier 150 alternately joined to the antenna switch 130 by a switch 160. Within the antenna switch 130, each transit path 120 is switchably coupled to the antenna 110 by a series switch 170 and optionally also switchably coupled to ground by a parallel switch 180.

As shown in FIG. 1, when one transit path 120 is coupled to the antenna 110 (said to be in the ON mode), the series switch 170 for that transit path 120 is closed while the parallel switch 180 is open, whereas the switches 170, 180 are reversed for all other transit paths 120 (OFF mode). While the antenna switch 130 will work with only the serial switches 170, the addition of the parallel switches 180 provides greater isolation by grounding the transit paths 120 that are not in use.

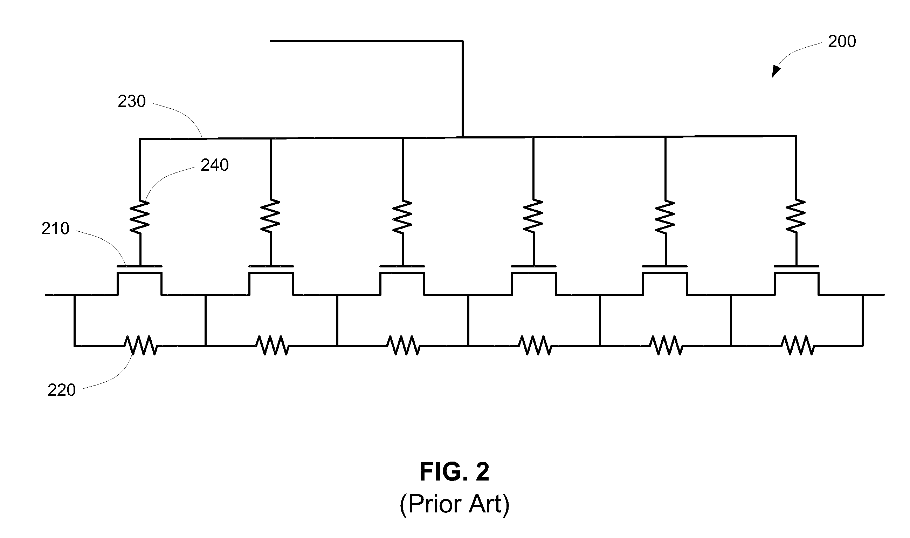

FIG. 2 illustrates a prior art switch 200 suitable for use as a switch 170, 180. Switch 200 comprises a number of series transistors 210 arranged in series, source to drain. The set of series transistors 210 within a switch 200 is sometimes referred to as a stack. A ladder resistor 220 is associated with each of the multiple transistors 210, the ladder resistor 220 for a given transistor 210 being connected in parallel between the source and the drain of that transistor 210. The gates of the multiple transistors 210 are controlled together by a bias network comprising a common control line 230 and a number of resistors 240, where each transistor 210 is connected to the common control line 230 by one of the resistors 240.

The overall capacitance of a transistor 210 between source and drain, when the switch 200 is off (OFF mode), is the contribution of the source to gate, drain to gate, source to channel, and drain to channel capacitances. The capacitance of the stack when the switch is in the OFF mode (Coff) in the capacitance of a single transistor 210 divided by the number of transistors 210 in the stack. The resistance of the stack when the switch is on (ON mode) is Ron, the sum of the individual resistances of the transistors 210. The product of Ron and Coff yields a Figure of Merit (Ron * Coff) which represents the RF performance of the switch. The lower the value of Ron * Coff the better the performance of the switch 200.

### SUMMARY

An exemplary switch of the present invention comprises two bias networks and a plurality of transistors arranged in series, each transistor of the plurality of transistors including a source, a drain, a channel disposed therebetween, and a gate to control the channel. The switch is defined in CMOS and /or the switch is defined on a silicon-on-insulator die, in various embodiments. The switch can be a component of an RF device that comprises, in addition to the switch described herein, a plurality of power amplifiers and an antenna. In these embodiments the switch described herein can be a serial switch within an antenna switch, where the antenna switch is configured to couple one of the plurality of power amplifiers at a time to the antenna. In these embodiments the antenna switch includes one such serial switch for each power amplifier.

Of the two bias networks of the exemplary switch, a first bias network is configured to bias the gates of the plurality of transistors while a second bias network is configured to bias the bodies, or at least the channels, of the plurality of transistors. In further embodiments, the switch further comprises a DC control configured to supply a variable bias voltage, and the first and second bias networks are configured to both receive the same variable bias voltage from the DC control. For example, the DC control can provide a variable bias voltage that varies from +2.5V to -2.5V and the same voltage is supplied to both bias networks. Various embodiments further comprise, for each transistor, a ladder resistor connected in parallel between the source and the drain of the transistor.

The second bias network optionally includes a resistor for each transistor of the plurality of transistors, wherein the resistors are arranged in series, wherein each resistor has a proximal end and a distal end, wherein each distal end of each resistor is associated with a node, and wherein each said node biases the channel of the corresponding transistor. The second bias network optionally can also include a first diode disposed between the DC control and the channels of the transistors. In embodiments that include the first forward-biased diode, the second bias network can further include second and third diodes in series with the first diode, the second and third diodes also being forward biased. In still other embodiments that include the first forward-biased diode, the second bias network can further comprise a second diode arranged in parallel to the first diode, the second diode being reverse biased.

### BRIEF DESCRIPTION OF THE DRAWINGS

FIG. 1 is a schematic representation of RF transceiver according to the prior art.
FIG. 2 is a schematic representation of a prior art switch usable as part of an antenna switch within the structure of FIG. 1.
FIG. 3 is a schematic representation of a switch according to various embodiments of the invention.
FIGs. 4A and 4B are cross-sectional views, orthogonal to one another, of a transistor configured to permit the channel thereof to be biased according to various embodiments of the invention.

### DETAILED DESCRIPTION

The present invention describes switches for use in RF applications such as phase shifters, step attenuators, and as serial 170 and parallel 180 switches in antenna switches 130, for example. The switches of the present invention provide better performance as expressed by an improved Ron * Coff as compared to switches of the prior art. Improvements are achieved by lowering the stack resistance in the ON mode and optionally by also lowering the stack capacitance in the OFF mode, both achieved by biasing the bodies of the transistors of the stack.

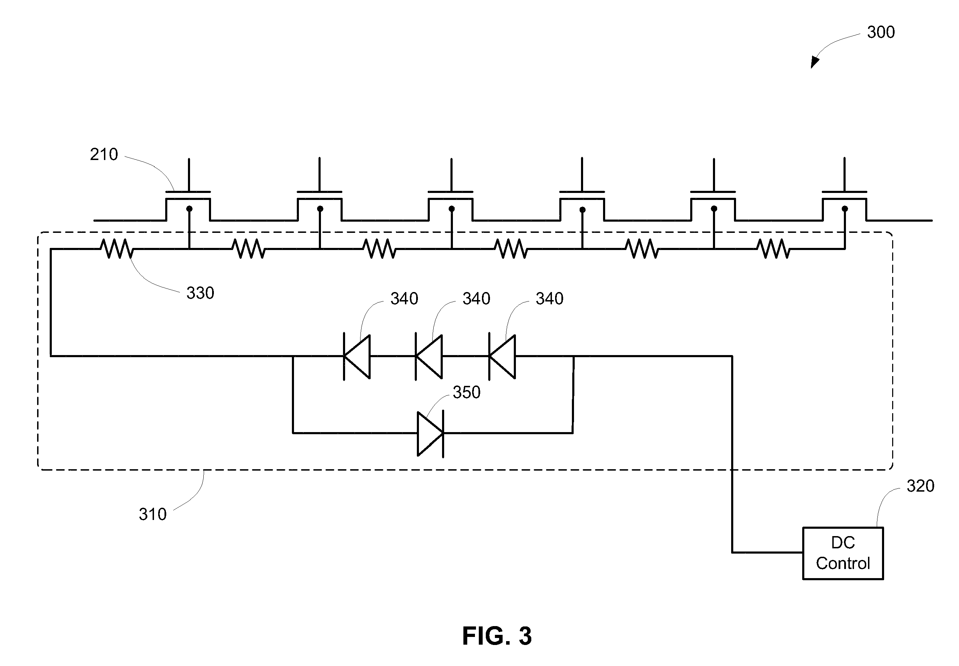

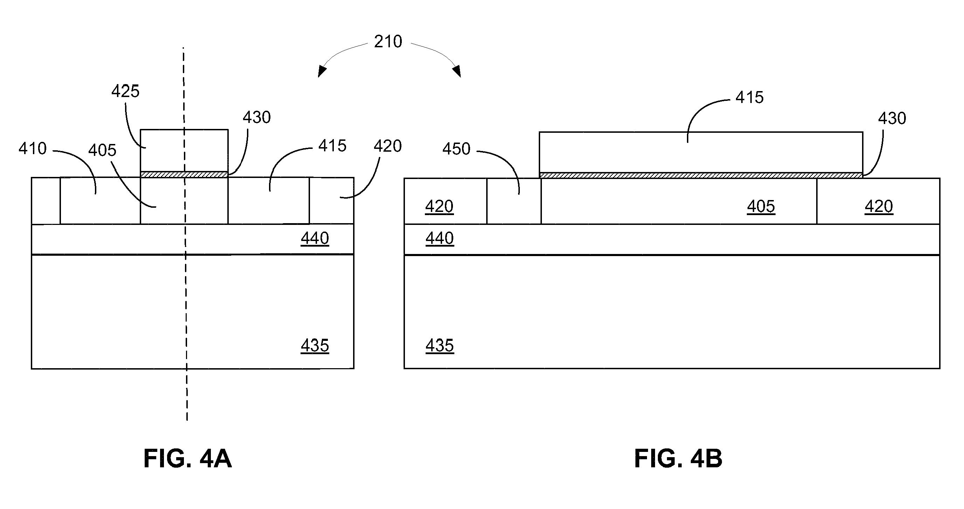

FIG. 3 illustrates an exemplary switch 300 of the present invention. The switch 300 comprises a plurality of transistors 210 arranged in series, each transistor 210 of the plurality of transistors including a source, a drain, a channel disposed therebetween, and a gate to control the channel. Cross-sections of an individual transistor 210 are provided below in FIGs. 4A and 4B. The switch 300 also comprises a first bias network (not shown) configured to bias the gates of the plurality of transistors 210. An exemplary first bias network is illustrated by FIG. 2 and further suitable bias network examples are provided by U.S. Patent Application No. 14/183,215, noted above.

The switch 300 further comprises a second bias network 310 configured to dynamically bias the bodies of the plurality of transistors 210, where the body of a transistor 210 includes the channel thereof. It will be understood that the first bias network and the second bias network 310 are separate networks, though they may receive the same control voltage from the same source in some embodiments. It will also be understood that biasing the gates and biasing the bodies are also separate acts that achieve different effects in the transistors 210. Being able to vary the bias applied to the channels of the transistors 210 allows for a lower stack resistance in the ON mode (Ron) for an improved Ron * Coff and thus better performance of the switch 300. Optionally, the second bias network 310 can also serve to lower the stack capacitance in the OFF mode (Coff), further improving the performance of the switch 300.

In various embodiments the switch 300 includes a DC control 320 that is a voltage supply configured to produce a variable bias voltage that is applied by the second bias network 310 to the bodies of the transistors 210. In some of these embodiments, the same DC control 320 also supplies the same bias voltage to the first bias network to turn the switch 300 on and off. Though not illustrated, it will be appreciated that the DC control 320 could be replaced by two DC controls, one that produces a positive bias and one the produces a negative bias.

In various embodiments the second bias network 310 includes, for each transistor 210, a resistor 330 connected in series. The resistors 330 are different from the ladder resistors 220 of the switch 200 (FIG. 2). Each resistor 330 includes a proximal end nearest the DC control 320 and a distal end furthest from the DC control 320, and a node at the distal end of each resistor 330 biases the channel of the corresponding transistor 210 as shown in FIG. 3. Each resistor 330 serves to keep the corresponding transistor 210 floating. It is noted that essentially no current flows in the second bias network 310, therefore, the voltage drop across each resistor 330 is negligible and the bias voltage applied to each body of each transistor 210 is effectively the same.

FIGs. 4A and 4B are cross-sectional views, orthogonal to one another, of a transistor 210 configured to permit a channel thereof to be biased, according to various embodiments of the invention. In the cross-sectional view of FIG. 4A, a channel 405 is defined between a source 410 and a drain 415 in a semiconductor material 420 such as silicon. A gate 425 is insulated from the channel 405 by a dielectric layer 430. The gate 425 controls the channel 405. In the illustrated example, the transistor 210 is built upon a silicon on insulator (SOI) substrate wherein the semiconductor material 420 is separated from a bulk substrate 435 by an insulator layer 440.

FIG. 4B is taken along the dashed vertical line through FIG. 4A. From this perspective it can be seen that the semiconductor material 420 includes a contact region 450 adjacent to the channel 405. Contact region 450 can be a heavily-doped region for example, such that an electrical connection can be made through the contact region to the channel 405. In this way the channel 405 of the transistor 210 is configured to be biased.

In various embodiments the second bias network 310 optionally includes one or more forward-biased diodes 340 disposed in series between the DC control 320 and the series resistors 330 biased. Other embodiments do not include any forward-biased diodes 340. In still further embodiments the second bias network 310 optionally includes one or more reverse-biased diodes 350 electrically disposed in parallel with the first diodes 340, when present, between the DC control 320 and the series resistors 330. Other embodiments do not include any reverse-biased diodes 350. The diodes 340, 350 create a voltage drop and therefore allow a lesser voltage to be applied to the channels 405 than the voltage produced by the DC control 320. If the DC control 320 is configured to produce the desired bias voltages, then diodes 340, 350 are not necessary.

In operation, when the switch 300 is in the ON mode, each transistor channel 405 is positively biased by the second bias network 310 to increase the transistor overdrive voltage, being the difference between the gate-to-source voltage and the smaller threshold voltage (VGS-VT), by lowering the threshold voltage. This is equivalent to raising the gate-to-source voltage. In the ON mode, increasing the transistor overdrive voltage serves to decrease the corresponding resistance of the transistors 210 of the stack, reducing Ron, and therefore the product Ron * Coff.

In some embodiments, a suitable positive bias in the ON mode for the transistor channels 405 is about +0.7V. In those embodiments where the DC control 320 provides to the second bias network 310 a positive bias of +2.5V, for example, that bias voltage would have to be reduced by about +1.8V in order to bring the applied positive bias down to the desired about +0.7V. Since the voltage drop across a diode 340, 350 is about +0.6V, the voltage drop across three forward-biased diodes 340 in series will be about + 1.8V. Therefore, three out forward-biased diodes 340 can be used to bring the applied bias to about +0.7V, as shown.

Similarly, when the switch 300 is in the OFF mode, each transistor channel 405 is negatively biased by the second bias network 310. This serves to reduce the overall capacitance of each transistor 210 in the OFF mode, thus reducing Coff and the product Ron * Coff. In some embodiments, a suitable negative bias in the OFF mode for the transistor channels 405 is about -1.9V. In those embodiments where the DC control 320 provides to the second bias network 310 a negative bias of -2.5V, for example, a single reverse-biased diode 350 is appropriate to drop the voltage by about +0.6V to bring the applied negative bias up to the desired about -1.9V.

While a DC control 320 may provide +2.5V to control the gates of the transistors 210 by the first bias network, and the same voltage may also be applied by the same DC control 320 to the second bias network 310 to bias the bodies of the transistors 210, the first and second bias networks are separate from one another, and in no instance does the second bias network 310 include an electrical connection between the gate and the channel, or body, of any transistor 210.

The various switches of the invention can be incorporated into antenna switches 130 for use in wireless RF devices such as smartphones (FIG. 1). In the various embodiments of the invention described above, the antenna switches 130 can be defined in CMOS and in further embodiments can be defined in a silicon-on-insulator (SOI) die or defined in an amorphous material such as sapphire. In some embodiments, the die including the antenna switch 130 can be a separate die from the die including the power amplifiers 140, while in other embodiments the antenna switch is integrated onto the same die as the power amplifiers 140. Integration into a single die can improve the performance of the power amplifier 140.

In the foregoing specification, the invention is described with reference to specific embodiments thereof, but those skilled in the art will recognize that the invention is not limited thereto. Various features and aspects of the above-described invention may be used individually or jointly. Further, the invention can be utilized in any number of environments and applications beyond those described herein without departing from the broader spirit and scope of the specification. The specification and drawings are, accordingly, to be regarded as illustrative rather than restrictive. It will be recognized that the terms "comprising," "including," and "having," as used herein, are specifically intended to be read as open-ended terms of art. The term "connect" is differentiated herein from the term "couple" such that when two components are "connected" there are no other components disposed between them, whereas when two components are "coupled" there may be other components disposed between them.

## Claims

1. A switch (300) comprising:
a plurality of transistors arranged in series, each transistor of the plurality of transistors including a source, a drain, a channel disposed therebetween, and a gate to control the channel;
a first bias network configured to bias the gates of the plurality of transistors; and
a second bias network (310) configured to bias the channels of the plurality of transistors.

2. The switch of claim 1 wherein the second bias network (310) includes a resistor for each transistor of the plurality of transistors, wherein the resistors are arranged in series, wherein each resistor has a proximal end and a distal end, wherein each distal end of each resistor is associated with a node, and wherein each said node biases the channel of the corresponding transistor.

3. The switch of claim 1 or 2 wherein the second bias network (310) includes a first diode (340), the first diode being forward biased.

4. The switch of claim 3 wherein the second bias network (310) further includes second and third diodes in series with the first diode (340), the second and third diodes (350) also being forward biased.

5. The switch of claim 3 further comprising a second diode arranged in parallel to the first diode (350), the second diode being reverse biased.

6. The switch according to any one of the preceding claims further comprising a DC control (320) configured to supply a variable bias voltage, wherein the first and second bias networks are configured to both receive the same variable bias voltage from the DC control.

7. The switch of according to any one of the preceding claims further comprising, for each transistor, a ladder resistor (220) connected in parallel between the source and the drain of the transistor.

8. The switch of according to any one of the preceding claims wherein the switch is defined in CMOS.

9. The switch of according to any one of the preceding claims wherein the switch is defined on a silicon-on-insulator die.

10. An RF device comprising:
a plurality of power amplifiers;
an antenna (110); and
an antenna switch (130) configured to couple one of the plurality of power amplifiers at a time to the antenna, the antenna switch including, for each power amplifier, a serial switch according to any one of the preceding claims.
